# EUROPEAN PATENT APPLICATION

(11) **EP 4 583 164 A1**
(43) Date of publication of application: **09.07.2025**
(21) Application number: 23860065.4
(22) Date of filing: 17.08.2023
(51) Int. Cl.: H01L 27/146, H04N 25/70, H04N 25/77, H04N 25/771

(54) **LIGHT DETECTION ELEMENT AND ELECTRONIC DEVICE**

(30) Priority: 29.08.2022 JP 2022135713
(71) Applicant: Sony Semiconductor Solutions Corporation, Atsugi-shi, Kanagawa 243-0014 (JP)
(72) Inventor: NAKAMURA, Ryosuke, Atsugi-shi, Kanagawa 243-0014 (JP); HATTORI, Yuki, Atsugi-shi, Kanagawa 243-0014 (JP)
(74) Representative: Müller Hoffmann & Partner
(86) International application number: PCT/JP2023/029717
(87) International publication number: WO 2024/048301

(57) **Abstract**

A photodetection element includes a plurality of pixels disposed in a planar direction, and an isolator that extends in a direction intersecting the planar direction between adjacent pixels of the plurality of pixels so as to isolate the adjacent pixels from each other, in which each of the plurality of pixels includes a photoelectric conversion element, and a plurality of transistors, and gate electrodes of specific transistors of the plurality of transistors of each of the adjacent pixels are arranged opposite to each other across the isolator and are connected to each other beyond the isolator in plan view.

## Description

### Field

The present disclosure relates to a photodetection element and an electronic apparatus.

### Background

For example, Patent Literature 1 discloses an imaging device including an isolator that isolates adjacent pixels from each other.

### Citation List

### Patent Literature

Patent Literature 1: JP 2020-194912 A

### Summary

### Technical Problem

The presence of the isolator restricts an arrangement of a photoelectric conversion element and a transistor in the pixel and reduces layout efficiency.

One aspect of the present disclosure improves layout efficiency.

### Solution to Problem

A photodetection element according to one aspect of the present disclosure includes: a plurality of pixels disposed in a planar direction; and an isolator that extends in a direction intersecting the planar direction between adjacent pixels of the plurality of pixels so as to isolate the adjacent pixels from each other, wherein each of the plurality of pixels includes a photoelectric conversion element, and a plurality of transistors, and gate electrodes of specific transistors of the plurality of transistors of each of the adjacent pixels are arranged opposite to each other across the isolator and are connected to each other beyond the isolator in plan view.

An electronic apparatus according to one aspect of the present disclosure includes a photodetection element, wherein the photodetection element includes a plurality of pixels disposed in a planar direction, and an isolator that extends in a direction intersecting the planar direction between adjacent pixels of the plurality of pixels so as to isolate the adjacent pixels from each other, each of the plurality of pixels includes a photoelectric conversion element, and a plurality of transistors, and gate electrodes of specific transistors of the plurality of transistors of each of the adjacent pixels are arranged opposite to each other across the isolator and are connected to each other beyond the isolator in plan view.

### Brief Description of Drawings

FIG. 1 is a diagram illustrating an example of a schematic configuration of an electronic apparatus including a photodetection element according to an embodiment.
FIG. 2 is a circuit diagram illustrating an example of a schematic configuration of a pixel.
FIG. 3 is a diagram illustrating an example of operation of the pixel.
FIG. 4 is a diagram illustrating a first configuration example of the photodetection element.
FIG. 5 is a diagram illustrating the first configuration example of the photodetection element.
FIG. 6 is a diagram illustrating the first configuration example of the photodetection element.
FIG. 7 is a diagram illustrating a second configuration example of the photodetection element.
FIG. 8 is a diagram illustrating the second configuration example of the photodetection element.
FIG. 9 is a diagram illustrating a third configuration example of the photodetection element.
FIG. 10 is a diagram illustrating the third configuration example of the photodetection element.
FIG. 11 is a diagram illustrating a fourth configuration example of the photodetection element.
FIG. 12 is a diagram illustrating the fourth configuration example of the photodetection element.
FIG. 13 is a diagram illustrating a fifth configuration example of the photodetection element.
FIG. 14 is a diagram illustrating the fifth configuration example of the photodetection element.
FIG. 15 is a diagram illustrating a sixth configuration example of the photodetection element.
FIG. 16 is a diagram illustrating the sixth configuration example of the photodetection element.
FIG. 17 is a diagram illustrating a seventh configuration example of the photodetection element.
FIG. 18 is a diagram illustrating the seventh configuration example of the photodetection element.
FIG. 19 is a block diagram depicting an example of schematic configuration of a vehicle control system.
FIG. 20 is a diagram of assistance in explaining an example of installation positions of an outside-vehicle information detecting section and an imaging section. Description of Embodiments

Hereinafter, embodiments of the present disclosure will be described in detail with reference to the drawings. Note that, in the following embodiments, the same elements are denoted by the same reference signs, and redundant description will be omitted.

The present disclosure will be described in accordance with the following order of items.
0. Introduction
1. Embodiments
1.1 First configuration example
1.2 Second configuration example
1.3 Third configuration example
1.4 Fourth configuration example
1.5 Fifth configuration example
1.6 Sixth configuration example
1.7 Seventh configuration example
2. Examples of effects
3. Application examples to mobile body

### 0. Introduction

As a device including a photodetection element and an electronic apparatus, a CMOS image sensor (CMOS type solid-state imaging device) and the like are known. A miniaturization technology associated with a CMOS process facilitates creation of an active structure having an amplification function for every pixel. In addition, a peripheral circuit unit such as a signal processing circuit that processes a signal output from each pixel of a pixel array unit can be integrated on the same chip (substrate) as the pixel array unit. Many technologies related to CMOS image sensors have been proposed.

For example, various technologies for expanding a dynamic range have been proposed. In a technology also referred to as lateral overflow integration capacitor (LOFIC) or the like, a capacitor is provided in a pixel to directly increase the amount of charge handled. There is also a technology in which large and small photoelectric conversion elements having different light receiving sensitivities are included in one pixel. There is also known a technology of a global shutter system in which exposure of all pixels is simultaneously started and exposure of all pixels is simultaneously ended as disclosed in Patent Literature 1. As the technology advances, a pixel architecture becomes complicated, and the number of elements such as transistors in the pixel has also increased.

In recent years, a deep insulator such as deep trench isolation (DTI) is often provided as an isolator for isolating elements between pixels. The presence of the isolator surrounding a pixel restricts an arrangement of a photoelectric conversion element and a transistor and reduces layout efficiency. A gate electrode is disposed apart from the isolator in order to avoid a short circuit risk. As a result, the size of the transistor becomes smaller, and the like, and a decrease in a saturation signal amount, a transfer failure, and the like can occur. Such a problem becomes more apparent due to an increase in the number of elements such as transistors accompanying miniaturization and high functionality of pixels.

At least some of the problems as described above are addressed by the disclosed technology. The elements of each of the adjacent pixels are arranged, for example, symmetrically across the isolator. The transistors located near the isolator of the transistors of the adjacent pixels share the gate electrode. Accordingly, an unnecessary space is eliminated, and the layout efficiency is improved.

### 1. Embodiments

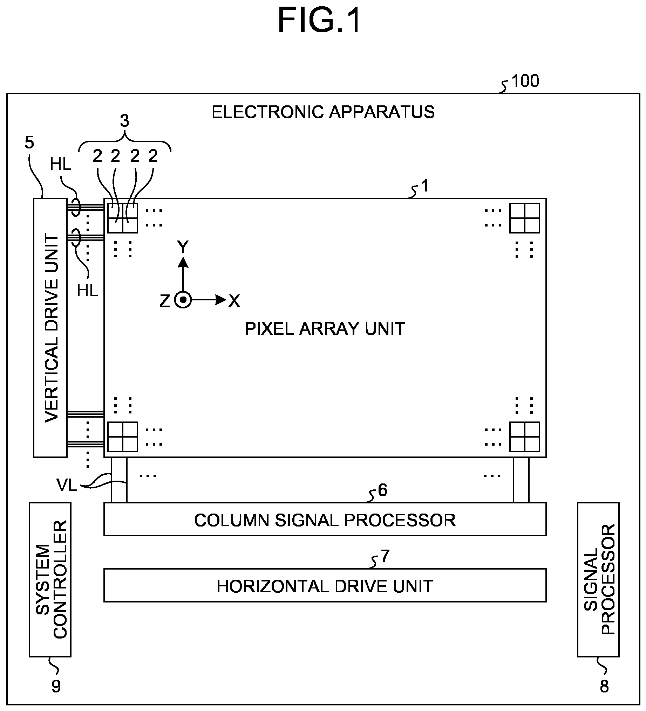

FIG. 1 is a diagram illustrating an example of a schematic configuration of an electronic apparatus including a photodetection element according to an embodiment. An illustrated electronic apparatus 100 is a CMOS image sensor and includes a pixel array unit 1 and a peripheral unit. These elements are formed, for example, on a semiconductor substrate of silicon or the like. As the peripheral unit, FIG. 1 illustrates a vertical drive unit 5, a column signal processor 6, a horizontal drive unit 7, a signal processor 8, and a system controller 9.

FIG. 1 also illustrates an XYZ coordinate system for the pixel array unit 1. An X-axis direction is also referred to as a horizontal direction (lateral direction) or the like. A Y-axis direction is also referred to as a vertical direction (longitudinal direction) or the like. A Z-axis direction is a direction orthogonal to an XY plane direction, and corresponds to, for example, a thickness direction of the semiconductor substrate.

The pixel array unit 1 includes a plurality of pixels 2. The plurality of pixels 2 is two-dimensionally arranged in the X-axis direction and the Y-axis direction. Each pixel 2 generates and outputs a voltage signal corresponding to the amount of received light. This signal is also referred to as a pixel signal.

At least some of the plurality of pixels 2 constitute a photodetection element 3. The photodetection element 3 includes at least two adjacent pixels of the plurality of pixels 2. The photodetection element 3 and the plurality of pixels 2 may be appropriately read as long as there is no contradiction.

The vertical drive unit 5 drives the plurality of pixels 2 of the pixel array unit 1, for example, all at the same time or for every pixel row. The driving includes selective scanning or the like of the plurality of pixels 2 row by row in order to read the pixel signal. The pixel signal of the selectively scanned pixel 2 is sent to the column signal processor 6.

The vertical drive unit 5 is connected to the pixel array unit 1 via a plurality of control lines HL for every pixel row, for example. Each control line HL extends in a row direction and connects each pixel 2 of the corresponding pixel row and the vertical drive unit 5. The vertical drive unit 5 includes, for example, a shift register, an address decoder, and the like.

In the present disclosure, being connected may be understood as being electrically connected. Being electrically connected may include being connected with another element interposed therebetween as long as the functions of the connected elements are not hindered.

The column signal processor 6 processes the pixel signal from each pixel 2 in the row selected by the vertical drive unit 5 for every pixel column. For example, the column signal processor 6 includes a plurality of unit circuits corresponding to the pixel columns. The processing by the column signal processor 6 includes noise removal processing, correlated double sampling (CDS) processing, double data sampling (DDS) processing, analog/digital (A/D) conversion processing of analog pixel signals, and the like. The pixel signal is digitized and sent to the signal processor 8.

The column signal processor 6 is connected to the pixel array unit 1 via a plurality of signal lines VL. Each signal line VL extends in a column direction and connects each pixel 2 of the corresponding pixel column and the column signal processor 6. The column signal processor 6 includes, for example, a shift register, an address decoder, and the like.

The horizontal drive unit 7 sequentially selects the unit circuits of the column signal processor 6. By being selectively scanned by the horizontal drive unit 7, the pixel signals for every pixel column processed by the column signal processor 6 is sequentially output to the signal processor 8. The horizontal drive unit 7 includes, for example, a shift register, an address decoder, and the like.

The signal processor 8 processes the pixel signal from the column signal processor 6, and generates and outputs an image signal based on the pixel signal. Note that data and the like most necessary for the processing can be temporarily stored in, for example, a storage (not illustrated).

The system controller 9 controls the vertical drive unit 5, the column signal processor 6, and the horizontal drive unit 7. For example, the system controller 9 includes a timing generator or the like so as to generate various timing signals and supply the timing signals to corresponding portions.

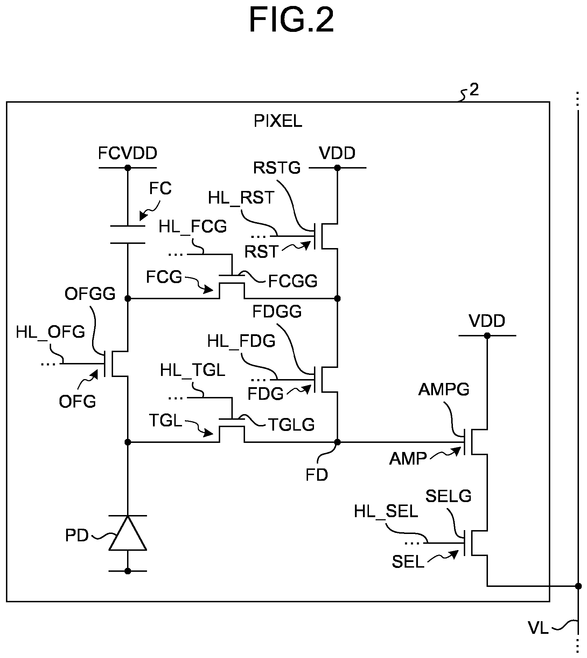

The pixel 2 of the pixel array unit 1 will be described with reference to FIG. 2.

FIG. 2 is a circuit diagram illustrating an example of a schematic configuration of a pixel. In this example, the pixel 2 includes a photoelectric conversion element PD, a floating diffusion FD, a capacitor FC, and a plurality of transistors. Examples of the plurality of transistors include a transistor TGL, a transistor FDG, a transistor FCG, a transistor OFG, a transistor RST, a transistor AMP, and a transistor SEL.

The exemplified transistor is an FET, and has a drain and a source which are current terminals, and a gate electrode which is a control terminal. Unless otherwise stated, connecting a transistor between two elements means that one current terminal (drain or source) of the transistor is connected to one element and the other current terminal of the transistor is connected to the other element.

The gate electrode of the transistor TGL is referred to as a gate electrode TGLG in the drawing. The gate electrode of the transistor FDG is referred to as a gate electrode FDGG in the drawing. The gate electrode of the transistor FCG is referred to as a gate electrode FCGG in the drawing. The gate electrode of the transistor OFG is referred to as a gate electrode OFGG in the drawing. The gate electrode of the transistor RST is referred to as a gate electrode RSTG in the drawing. The gate electrode of the transistor AMP is referred to as a gate electrode AMPG in the drawing. The gate electrode of the transistor SEL is referred to as a gate electrode SELG in the drawing. The gate of the transistor AMP is connected to the floating diffusion FD.

Of the plurality of control lines HL connected to one pixel 2, the control line HL connected to the gate electrode TGLG of the transistor TGL is referred to as a control line HL_TGL in the drawing. The control line HL connected to the gate electrode FDGG of the transistor FDG is referred to as a control line HL_FDG in the drawing. The control line HL connected to the gate electrode FCGG of the transistor FCG is referred to as a control line HL_FCG in the drawing. The control line HL connected to the gate electrode OFGG of the transistor OFG is referred to as a control line HL_OFG in the drawing. The control line HL connected to the gate electrode RSTG of the transistor RST is referred to as a control line HL_RST in the drawing. The control line HL connected to the gate electrode SELG of the transistor SEL is referred to as a control line HL_SEL in the drawing. The ON/OFF state (conductive state or non-conductive state) of each transistor is controlled by a control signal from the corresponding control line HL.

The photoelectric conversion element PD generates and accumulates charge corresponding to the amount of received light. An example of the photoelectric conversion element PD is a photodiode or the like.

The transistor TGL is a transfer transistor for transferring the charge of the photoelectric conversion element PD to the floating diffusion FD. The transistor TGL is connected between the photoelectric conversion element PD and the floating diffusion FD.

The floating diffusion FD accumulates the charge from the photoelectric conversion element PD transferred via the transfer transistor TGL and converts the charge into a voltage. A voltage corresponding to the amount of the accumulated charge is generated. The floating diffusion FD is formed to have a floating diffusion capacitance at least between the transistor TGL, the transistor AMP, and the transistor FDG.

The transistor FDG is a conversion efficiency switching transistor that switches conversion efficiency from charge to voltage in the floating diffusion FD. The transistor FDG is connected between the floating diffusion FD and the transistor RST and the transistor FCG. When the transistor FDG is turned on, the region of the floating diffusion FD spreads to a region opposite to the floating diffusion FD across the FDG, and the capacitance of the floating diffusion FD increases accordingly. When the capacitance of the floating diffusion FD increases, the voltage change to the change in the amount of accumulated charge becomes gentle accordingly, and the conversion efficiency decreases. Conversely, when the transistor FDG is turned off, the capacitance of the floating diffusion FD decreases, and the conversion efficiency increases accordingly.

The transistor FCG is a capacitive connection transistor for connecting the capacitor FC to the floating diffusion FD. The transistor FCG is connected between the transistor FDG and the transistor RST, and the capacitor FC and the transistor OFG.

The transistor OFG is an overflow transistor (overflow gate) for transferring charge overflowed from the photoelectric conversion element PD to the capacitor FC. The transistor OFG is connected between the photoelectric conversion element PD and the capacitor FC and the transistor FCG.

The capacitor FC is used to accumulate the charge overflowing from the photoelectric conversion element PD. The capacitor FC is connected between (the node of) a power supply voltage FCVDD and the transistor OFG and the transistor FCG. The capacitor FC has, for example, a metal-insulator-metal (MIM) structure, and the capacitor FC in that case is an MIM capacitor.

The transistor RST is a reset transistor for discharging the charge accumulated in the floating diffusion FD. The transistor RST is connected between (the node of) a power supply voltage VDD and the transistor FDG and the transistor FCG.

The transistor AMP is an amplifier transistor that outputs a voltage signal corresponding to the voltage of the floating diffusion FD. The transistor AMP is connected between the power supply voltage VDD and the transistor SEL. The voltage signal output from the transistor AMP can correspond to a pixel signal.

The transistor SEL is a selection transistor for selectively outputting the voltage signal output from the transistor AMP to the signal line VL. The transistor SEL is connected between the transistor AMP and the signal line VL.

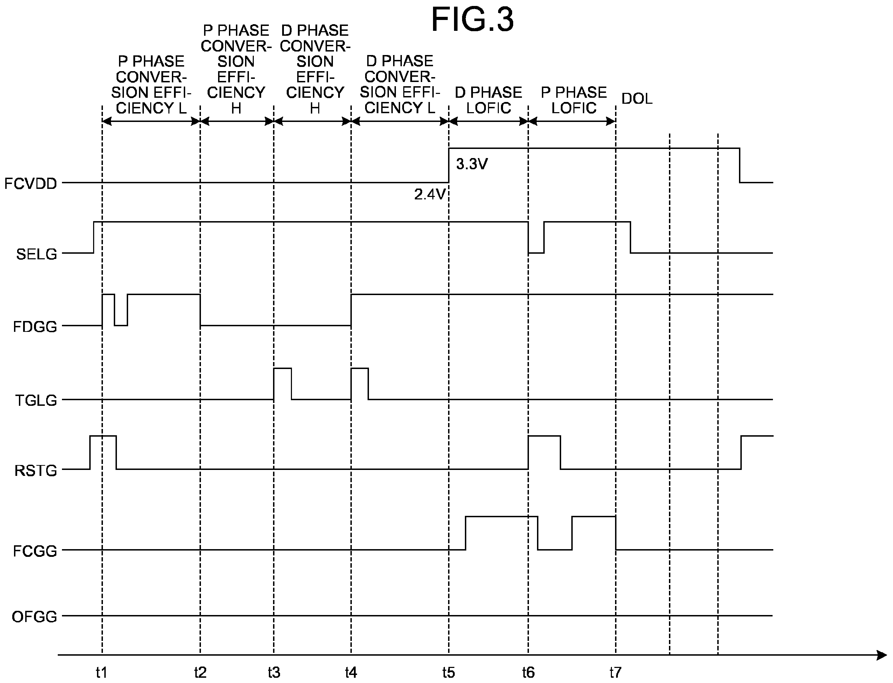

An example of operation of the pixel 2 having the above configuration will be described with reference to FIG. 3.

FIG. 3 is a diagram illustrating an example of operation of the pixel. An example of a timing chart when pixel signals are read is illustrated. The power supply voltage FCVDD is controlled to either 2.4 V or 3.3 V. Although the power supply voltage FCVDD may be constant, the lower the power supply voltage FCVDD, the higher the possibility that a dark current can be suppressed. Therefore, in this example, the power supply voltage FCVDD is controlled to 3.3 V only after a LOFIC period described later. Each gate electrode (such as gate electrode SELG) is controlled to either a low voltage for turning off the corresponding transistor or a high voltage for turning on the transistor.

A period from time t1 to time t3 is a period in which a pixel signal (reset voltage signal) when the floating diffusion FD is reset is read. This period is also referred to as a P-phase (precharge phase) period. The gate electrode SELG is maintained at a high voltage. The gate electrode RSTG and the gate electrode FDGG have a high voltage, and the floating diffusion FD is reset. A period from time t1 to time t2 is a period in which the conversion efficiency is low (conversion efficiency L), and the gate electrode FDGG has a high voltage, that is, the transistor FDG is turned on. The pixel signal in a state where the capacitance of the floating diffusion FD is expanded is sent to the column signal processor 6 via the signal line VL. A period from time t2 to time t3 is a period in which the conversion efficiency is high (conversion efficiency H), the gate electrode FDGG has a low voltage, and the transistor FDG is turned off. The pixel signal in a state where the capacitance of the floating diffusion FD is not expanded is sent to the column signal processor 6 via the signal line VL.

A period from time t3 to time t5 is a period in which the pixel signal corresponding to the charge accumulated in the photoelectric conversion element PD is read out. This period is also referred to as a D-phase (data phase) period. A period from time t3 to time t4 is a period in which the conversion efficiency is high (conversion efficiency H), and in a state where the gate electrode FDGG is maintained at a low voltage, the gate electrode TGLG has a high voltage. The charge accumulated in the photoelectric conversion element PD is transferred to the floating diffusion FD, and the pixel signal is sent to the column signal processor 6 via the signal line VL. A period from time t4 to time t5 is a period in which the conversion efficiency is low (conversion efficiency L), and in a state in which the gate electrode FDGG is maintained at a high voltage, the gate electrode TGLG has a high voltage. The charge accumulated in the photoelectric conversion element PD is transferred to the floating diffusion FD, and the pixel signal is sent to the column signal processor 6 via the signal line VL.

By the CDS processing of the column signal processor 6 described above, reset noise and the like are removed on the basis of the pixel signal read in the P-phase period and the pixel signal read in the D-phase period.

A period from time t5 to time t7 is a period in which the pixel signal is read by using the capacitor FC. This period is also referred to as a lateral overflow integration capacitor (LOFIC) period. In a state where the gate electrode FDGG is maintained at a high voltage, the gate electrode FCGG also has a high voltage. Not only the transistor FDG but also the transistor FCG is turned on. In a state where the capacitor FC is connected to the floating diffusion FD, the pixel signal is sent to the column signal processor 6 via the signal line VL. A period from time t5 to time t6 is a D-phase period, and a period from time t6 to time t7 is a P-phase period. At the beginning of the P-phase period, the gate electrode RSTG has a high voltage, and the floating diffusion FD is reset. On the pixel signal in the LOFIC period, for example, the DDS processing of the column signal processor 6 described above is executed.

In the example illustrated in FIG. 3, a short period after time t7 is provided as a digital overlap (DOL) period. The voltage of the gate electrode SELG is maintained at a high voltage only during the period, and the pixel signal is extracted via the signal line VL. It is also possible to cope with a case where the amount of received light is extremely large.

For example, as described above, the plurality of pixels 2 operate by controlling the voltages of the gate electrodes of the various transistors.

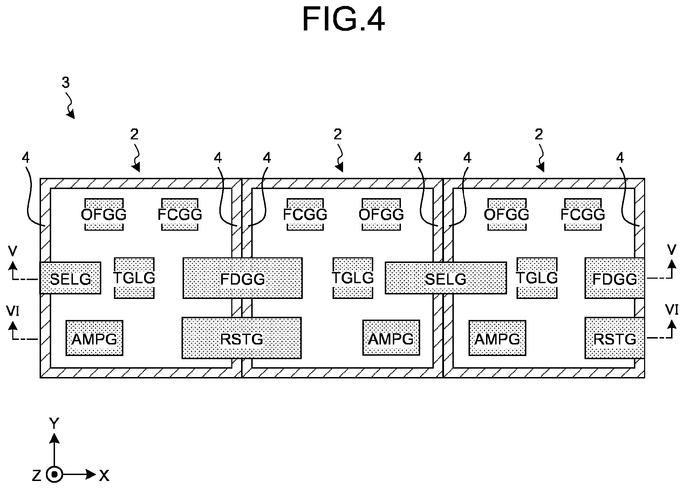

In the present embodiment, the layout efficiency is improved by make some gate electrodes common. Some examples of specific configurations will be described with reference to FIG. 4 and subsequent drawings.

### 1.1 First configuration example

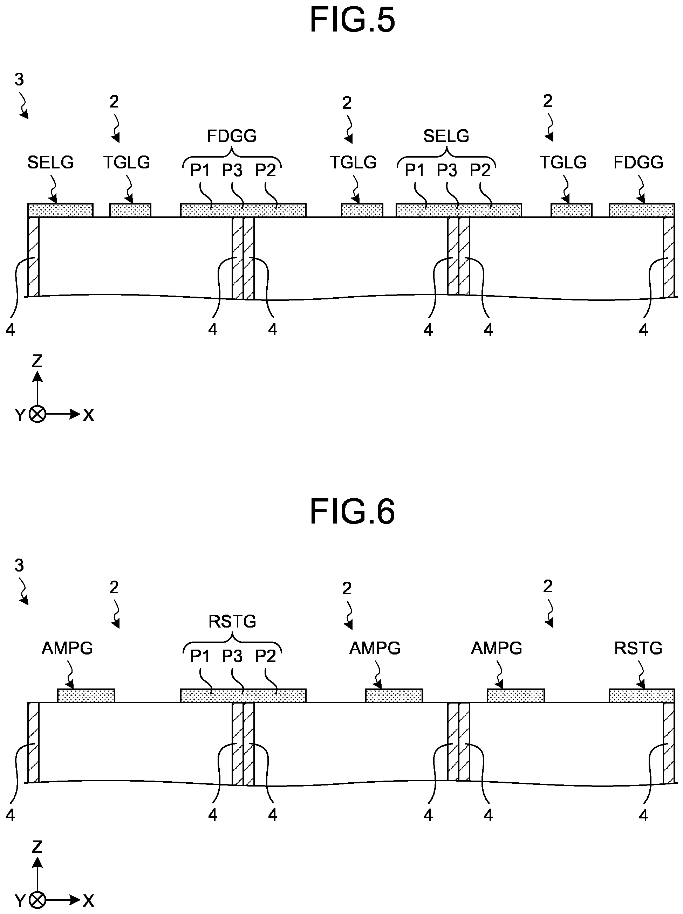

FIGS. 4 to 6 are diagrams illustrating a first configuration example of the photodetection element. Three pixels 2 arranged side by side in the X-axis direction are exemplified. FIG. 4 schematically illustrates a planar layout of each electrode. FIG. 5 schematically illustrates a cross section taken along line V-V in FIG. 4. FIG. 6 schematically illustrates a cross section taken along line VI-VI in FIG. 4. In the following description, a plan view means that the photodetection element 3, that is, the plurality of pixels 2 is viewed in a plan view (viewed in the Z-axis direction).

The photodetection element 3 includes an isolator 4. The isolator 4 isolates the adjacent pixels 2 from each other. The isolation by the isolator 4 includes at least one of electrical isolation or optical isolation. In this example, the isolator 4 is provided so as to surround each pixel 2 in plan view (when viewed in the Z-axis direction). The isolator 4 extends between the adjacent pixels 2 in a direction intersecting the XY plane direction, in this example, the Z-axis direction. The isolator 4 can also be said to be a wall that partitions the adjacent pixels 2. Each element of one pixel 2, for example, the photoelectric conversion element PD, the floating diffusion FD, various transistors, the capacitor FC, and the like described above are formed in one region partitioned by the isolator 4.

The isolator 4 may include, for example, a single-layer film or a multi-layer film of an insulator such as silicon oxide (SiO₂), tantalum oxide (Ta₂O₅), hafnium oxide (HfO₂), or aluminum oxide (Al₂O₃). The isolator 4 may include a laminate of a single-layer film or a multilayer film of an insulator such as tantalum oxide, hafnium oxide, or aluminum oxide and a silicon oxide film. The isolator 4 may have a gap inside. The isolator 4 may include a metal having a high light shielding property, such as tantalum (Ta), aluminum (Al), silver (Ag), gold (Au), or copper (Cu). Polysilicon (polycrystalline silicon) may be used as a material of the isolator 4.

In the present embodiment, in plan view, the gate electrodes of specific transistors of the plurality of transistors of each of the adjacent pixels 2 are disposed opposite to each other across the isolator 4, and are connected to each other beyond the isolator 4. Specifically, in the example illustrated in FIG. 4, the gate electrode FDGG of the transistor FDG, the gate electrode RSTG of the transistor RST, and the gate electrode SELG of the transistor SEL are gate electrodes of specific transistors. The gates of such specific transistors are connected by, for example, a metal wire extending in the X-axis direction (horizontal direction), and thus can be connected to each other beyond the isolator 4.

The gate electrodes of the transistors other than the specific transistors are disposed in a region other than a region between the gate electrodes of the specific transistors of the adjacent pixels 2. Specifically, in the example illustrated in FIG. 4, the gate electrode TGLG of the transistor TGL, the gate electrode FCGG of the transistor FCG, the gate electrode OFGG of the transistor OFG, and the gate electrode AMPG of the transistor AMP are gate electrodes of transistors other than the specific transistors. The gate electrode TGLG, the gate electrode FCGG, the gate electrode OFGG, and the gate electrode AMPG are disposed in a region other than a region between the gate electrodes FDGG of the adjacent pixels 2, a region other than a region between the gate electrodes RSTG, and a region other than a region between the gate electrodes SELG.

In the example illustrated in FIG. 4, the gate electrodes of the transistors of each of the adjacent pixels 2 are arranged symmetrically with respect to each other across the isolator 4. This arrangement can also be referred to as a mirror arrangement in the X-axis direction (mirror arrangement across the Y-axis). It is possible to facilitate layout design and the like. Not only the gate electrode but also the transistor itself and elements of other circuits may be arranged symmetrically. Note that another pattern (not illustrated), for example, a ground pattern or the like may also be provided.

FIG. 5 schematically illustrates a cross section of a portion including the gate electrode FDGG and the gate electrode SELG beyond the isolator 4. Elements other than the isolator 4 and the gate electrode are not illustrated. The same applies to other sectional views.

The gate electrode FDGG includes a first portion P1, a second portion P2, and a third portion P3. The first portion P1 of the gate electrode FDGG is a portion located in one pixel of the pixels 2 adjacent in the X-axis direction (in this example, the pixel 2 on an X-axis negative direction side). The second portion P2 is a portion located in the other pixel (in this example, the pixel 2 on an X-axis positive direction side). The third portion P3 is a portion located on the isolator 4 and connected between the first portion P1 and the second portion P2.

Each portion of the gate electrode SELG is also referred to as a first portion P1, a second portion P2, and a third portion P3 in the drawing. These portions are similar to the corresponding portions of the gate electrode FDGG described above.

FIG. 6 schematically illustrates a cross section of a portion including the gate electrode RSTG. Each portion of the gate electrode RST is also referred to as a first portion P1, a second portion P2, and a third portion P3 in the drawing. These portions are also similar to the corresponding portions of the gate electrode FDGG described above.

In the photodetection element 3 having the configuration described above, the gate electrode of the specific transistor shared between the adjacent pixels 2 does not need to be disposed apart from the photodetection element 3. Accordingly, the layout efficiency can be improved. For example, by increasing the area of the gate electrode, the operation can be stabilized and the transfer performance can be improved. The signal saturation can be also suppressed. In the electronic apparatus 100 including the photodetection element 3, advantages such as miniaturization and high performance can be obtained.

### 1.2 Second configuration example

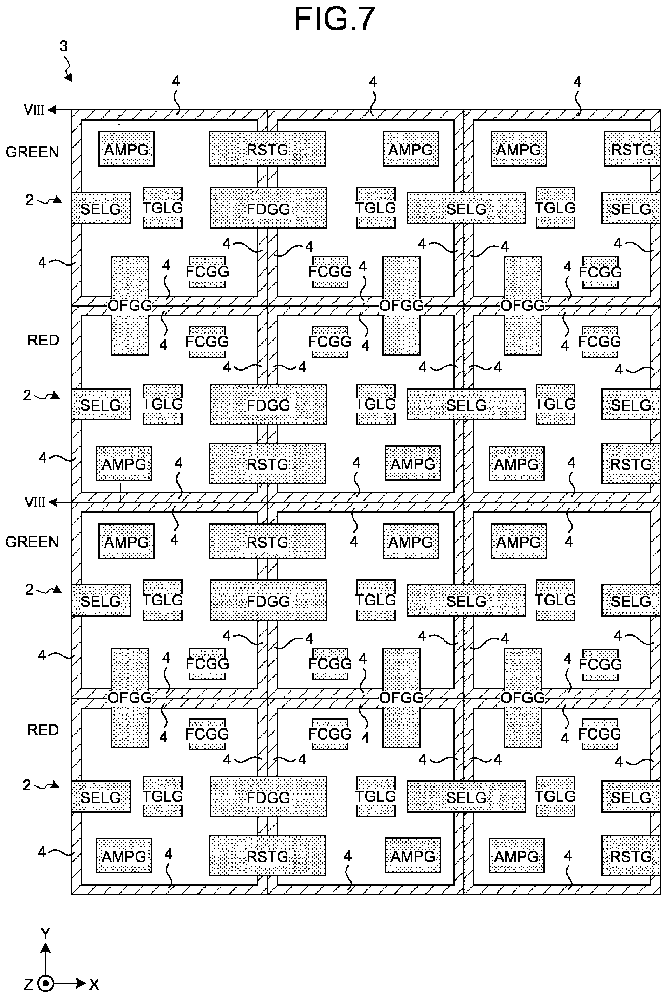

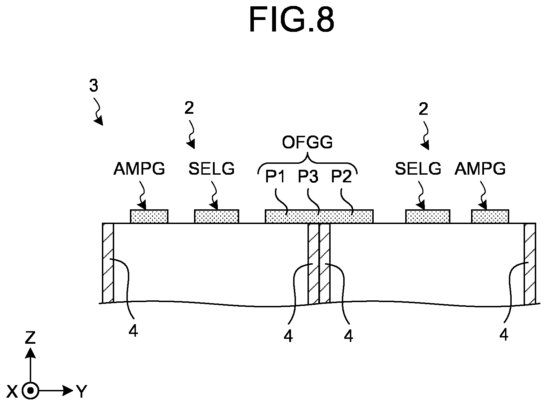

FIGS. 7 and 8 are diagrams illustrating a second configuration example of the photodetection element. Several pixels 2 arranged in a Bayer array are exemplified. In this example, it is assumed that the pixel signals of the pixels 2 corresponding to the same color (red, green, or the like) are read together by skipping one row. FIG. 7 schematically illustrates a planar layout of each electrode. FIG. 8 schematically illustrates a cross section taken along line VIII-VIII in FIG. 7.

In this example, the transistor OFG of the transistor OFG is also a gate electrode of a specific transistor. Specifically, the gate electrodes OFGG of the transistors OFG of the pixels 2 adjacent in the Y-axis direction are disposed opposite to each other across the isolator 4, and are connected to each other beyond the isolator 4. The gate electrode TGLG of the transistor TGL, the gate electrode FCGG of the transistor FCG, and the gate electrode AMPG of the transistor AMP are gate electrodes of transistors other than the specific transistors. The gate electrode TGLG, the gate electrode FCGG, and the gate electrode AMPG are disposed in a region other than a region between the gate electrodes FDGG of the adjacent pixels 2, a region other than a region between the gate electrodes RSTG, a region other than a region between the gate electrodes SELG, and a region other than a region between the gate electrodes OFGG. The gate electrodes of the transistors of each of the pixels 2 adjacent in the Y-axis direction may be arranged symmetrically with respect to each other across the isolator 4 (mirror arrangement across the X-axis in the Y-axis direction).

FIG. 8 schematically illustrates a cross section of a portion including the gate electrode OFGG beyond the isolator 4. Each portion of the gate electrode OFGG is also referred to as a first portion P1, a second portion P2, and a third portion P3 in the drawing. The first portion P1 of the gate electrode OFGG is a portion located in one pixel of the pixels 2 adjacent in the Y-axis direction (in this example, the pixel 2 on a Y-axis negative direction side). The second portion P2 is a portion located in the other pixel (in this example, the pixel 2 on a Y-axis positive direction side). The third portion P3 is a portion located on the isolator 4 and connected between the first portion P1 and the second portion P2.

In the above configuration, the control line HL_OFG (FIG. 2) connected to the gate electrode OFGG of each of the pixels 2 adjacent in the Y-axis direction can also be made common. As a result, the number of control lines HL_OFG for two pixels can be reduced from two to one. By reducing the number of control lines HL, the degree of freedom of a wiring layout is improved. For example, the possibility of improving an RC time constant or reducing a yield reduction due to dust is also increased. The same may apply to the case of simultaneously reading four pixels of the same color.

### 1.3 Third configuration example

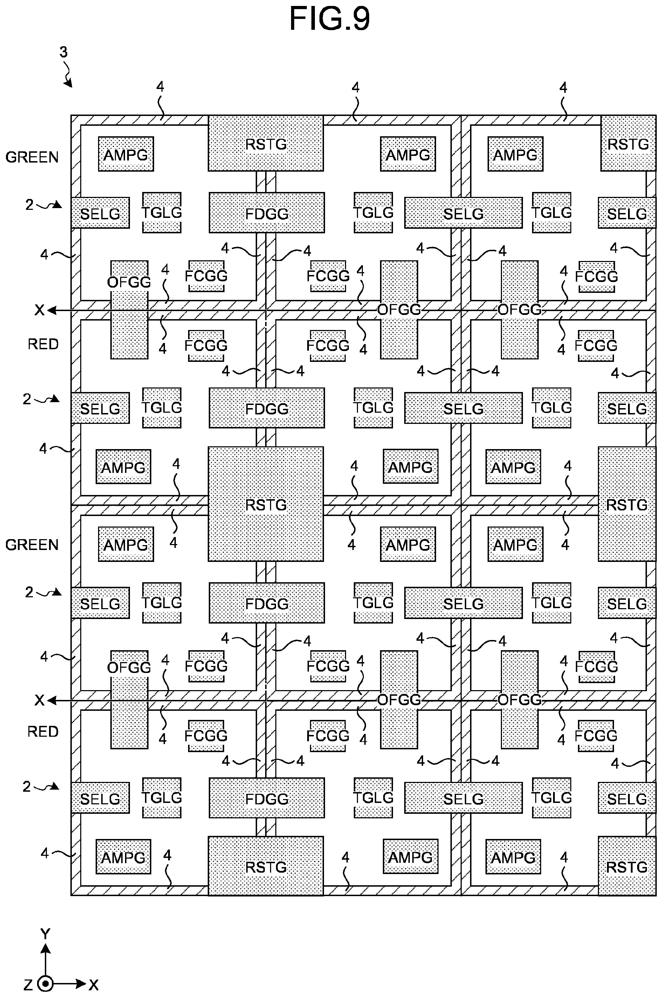

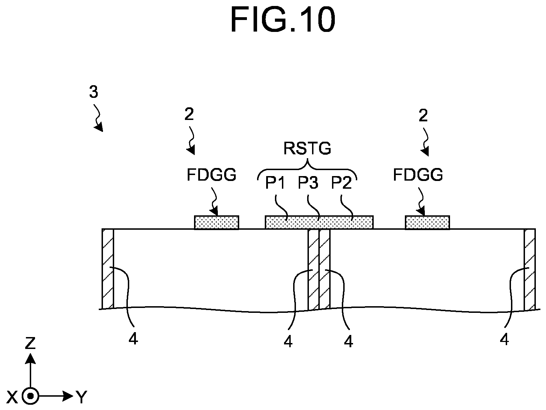

FIGS. 9 and 10 are diagrams illustrating a third configuration example of the photodetection element. The arrangement of the pixel is similar to the arrangement in FIGS. 7 and 8 described above. Here, it is assumed that the pixel signals of the pixels 2 adjacent in the Y-axis direction and corresponding to different colors are read together. In this case, the gate electrodes RSTG of the pixels 2 adjacent in the Y-axis direction are also shared. This is because it is possible to perform reset at the same timing for simultaneous reading. FIG. 9 schematically illustrates a planar layout of each electrode. FIG. 10 schematically illustrates a cross section taken along line X-X in FIG. 9.

FIG. 10 schematically illustrates a cross section of a portion including the gate electrode RSTG beyond the isolator 4 in the Y-axis direction. Each portion of the gate electrode RSTG is also referred to as a first portion P1, a second portion P2, and a third portion P3 in the drawing. These portions are similar to the corresponding portions of the gate electrode OFGG (FIG. 8) described above.

In the above configuration, the control line HL_RST (FIG. 2) connected to the gate electrode RSTG of each pixel 2 adjacent in the Y-axis direction can be also made common. As described above, the number of control lines HL can be reduced, and the degree of freedom of wiring can be improved.

### 1.4 Fourth configuration example

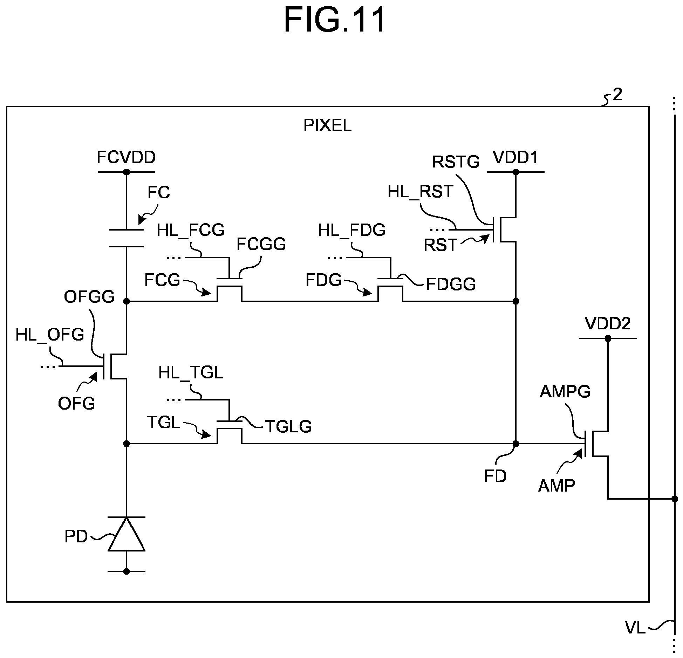

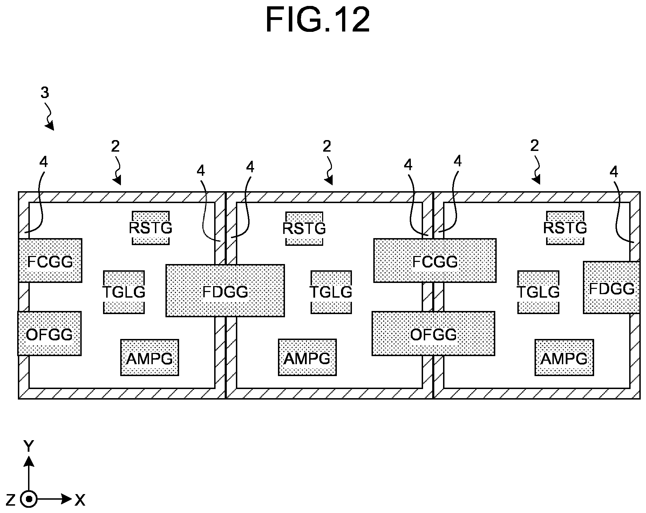

FIGS. 11 and 12 are diagrams illustrating a fourth configuration example of the photodetection element. FIG. 11 illustrates an example of a circuit of the pixel 2. FIG. 12 schematically illustrates a planar layout of each electrode. The transistor FDG is connected between the floating diffusion FD and the transistor RST and the transistor FCG. (The node of) the power supply voltage connected to the transistor RST is referred to as a power supply voltage VDD1 in the drawing. The transistor AMP is connected between a power supply voltage VDD2 different from the power supply voltage VDD1 and the signal line VL.

The power supply voltage VDD1 is controlled to be switchable between a high voltage and a low voltage. By controlling the power supply voltage VDD1 to change an input voltage of the transistor AMP, the transistor AMP can have the function of the transistor SEL described above. For example, the power supply voltage VDD1 is switched between a high voltage and a low voltage by a control signal of the transistor SEL. Since the pixel 2 does not include the transistor SEL, the circuit configuration is simplified, and advantages such as improvement in the layout efficiency can be obtained.

Since there is no transistor SEL, the gate electrode SELG is also excluded from the planar layout. The gate electrode FDGG, the gate electrode FCGG, and the gate electrode OFGG of each of the pixels 2 adjacent in the X-axis direction are shared. These gate electrodes are connected by, for example, a metal wire extending in the X-axis direction (horizontal direction), and thus can be connected to each other beyond the isolator 4.

### 1.5 Fifth configuration example

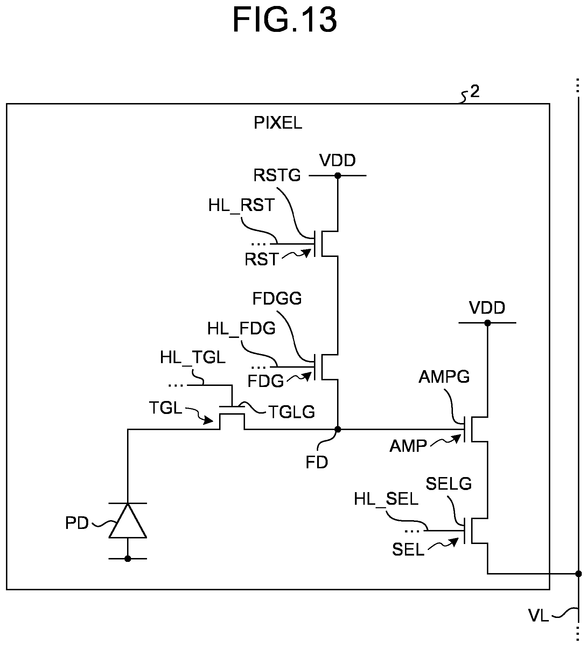

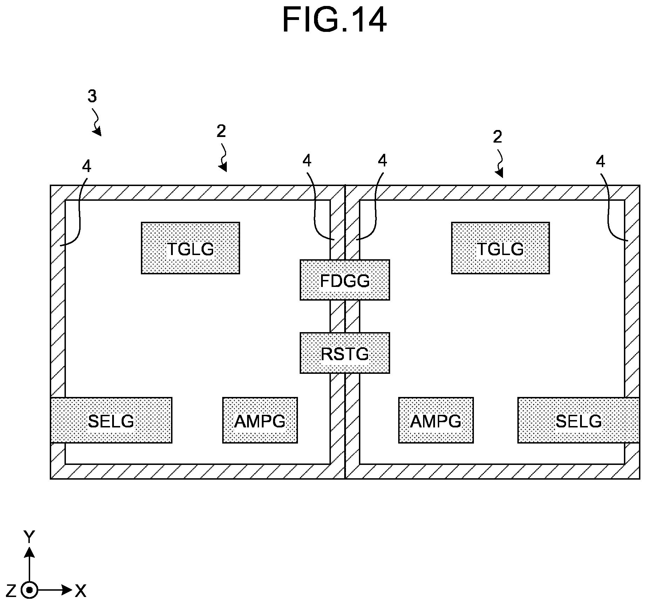

FIGS. 13 and 14 are diagrams illustrating a fifth configuration example of the photodetection element. FIG. 13 is a circuit diagram of the pixel 2. The exemplified pixel 2 is different from the configuration described above in that the transistor FCG, the capacitor FC, and the transistor OFG are not included. FIG. 14 schematically illustrates a planar layout of each electrode. The gate electrode FDGG, the gate electrode RSTG, and the gate electrode SELG are gate electrodes of a specific transistor. The gate electrodes FDGG of the pixels 2 adjacent in the X-axis direction are disposed opposite to each other across the isolator 4, and are connected to each other beyond the isolator 4. The same applies to the gate electrode RSTG and the gate electrode SELG.

### 1.6 Sixth configuration example

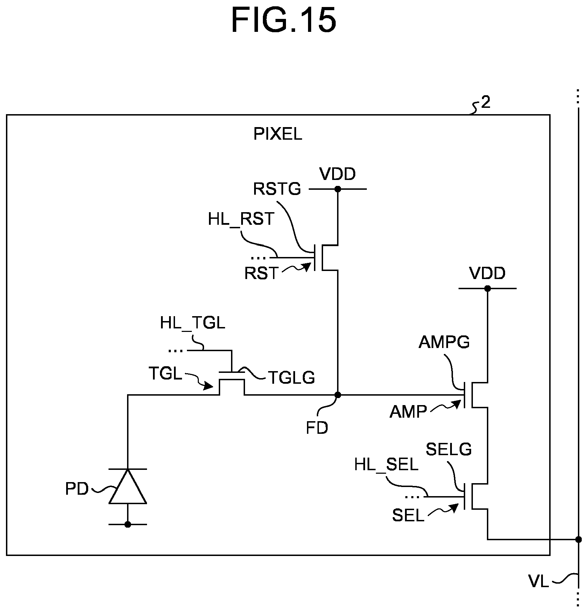

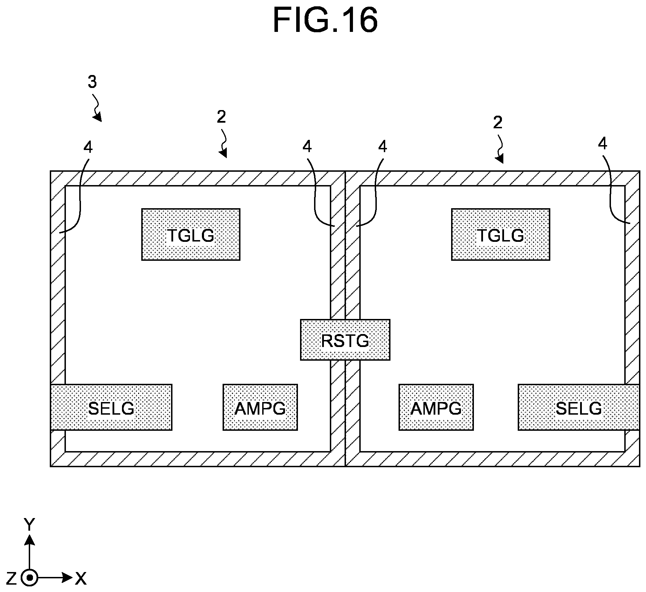

FIGS. 15 and 16 are diagrams illustrating a sixth configuration example of the photodetection element. FIG. 15 is a circuit diagram of the pixel 2. The exemplified pixel 2 is different from the configuration in FIG. 13 in that the pixel 2 does not include the transistor FDG. FIG. 16 schematically illustrates a planar layout of each electrode. The gate electrode RSTG and the gate electrode SELG are gate electrodes of a specific transistor.

### 1.7 Seventh configuration example

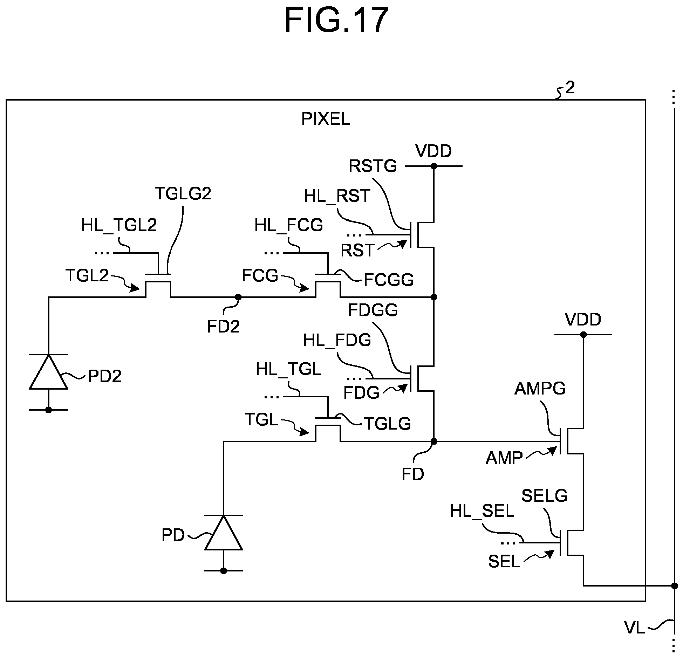

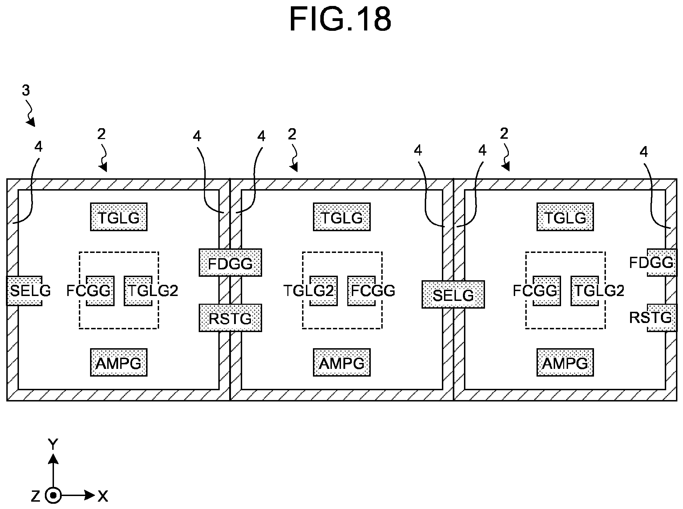

FIGS. 17 and 18 are diagrams illustrating a seventh configuration example of the photodetection element. FIG. 17 is a circuit diagram of the pixel 2. The exemplified pixel 2 further includes a photoelectric conversion element PD2, a transistor TGL2, and a floating diffusion FD2 as compared with the configuration in FIG. 2 described above. The transistor TGL2 is a second transfer transistor for transferring the charge of the photoelectric conversion element PD2 to the floating diffusion FD2. The transistor FCG is connected between the floating diffusion FD2 and the transistor RST and the transistor FDG. The gate electrode of the transistor TGL2 is referred to as a gate electrode TGLG2 in the drawing. The control line HL connected to the gate electrode TGLG2 is referred to as a control line HL_TGL2 in the drawing.

The photoelectric conversion element PD and the photoelectric conversion element PD2 have different light receiving sensitivities. The photoelectric conversion element PD2 is designed to be smaller than the photoelectric conversion element PD, specifically, to have an area smaller than a light receiving area of the photoelectric conversion element PD. It can be said that the pixel 2 includes a large pixel including the photoelectric conversion element PD and a small pixel including the photoelectric conversion element PD2. By using the two light receiving elements of the photoelectric conversion element PD and the photoelectric conversion element PD2 in combination, it is possible to cope with a wide range of amounts of received light, and it is possible to expand the dynamic range accordingly.

In plan view of the photodetection element 3, the gate electrode of the transistor connected to the photoelectric conversion element PD2 is disposed closer to the center of the pixel 2 than the gate electrode of the transistor connected to the photoelectric conversion element PD. FIG. 18 schematically illustrates a planar layout of each electrode. A region of a central portion of the pixel 2 is indicated by a broken line. The photoelectric conversion element PD2, the gate electrode TGLG2 of the transistor TGL2 connected to the photoelectric conversion element PD2, the floating diffusion FD2, the gate electrode FCGG of the transistor FCG, and the like are disposed inside a region indicated by the broken line. The photoelectric conversion element PD, the gate electrode TGLG of the transistor TGL connected to the photoelectric conversion element PD, the gate electrode FDGG of the transistor FDG, the gate electrode RSTG of the transistor RST, the transistor AMP of the transistor AMP, the gate electrode SELG of the transistor SEL, and the like are disposed outside a region indicated by the broken line. The gate electrode FDGG, the gate electrode RSTG, and the gate electrode SELG are gate electrodes of a specific transistor.

### 2. Examples of effects

The technology described above is specified as follows, for example. One of the disclosed technologies is a photodetection element 3. As described with reference to FIGS. 1 to 6 and the like, the photodetection element 3 includes the plurality of pixels 2 disposed in the XY plane direction, and the isolator 4 extending in a direction intersecting the XY plane direction (for example, the Z-axis direction) between the adjacent pixels 2 so as to isolate the adjacent pixels 2 of the plurality of pixels 2. Each of the plurality of pixels 2 includes a photoelectric conversion element PD and a plurality of transistors. In plan view(when viewed in the Z-axis direction), the gate electrodes of specific transistors of the plurality of transistors of each of the adjacent pixels 2 are disposed opposite to each other across the isolator 4, and are connected to each other beyond the isolator 4.

In the photodetection element 3, for example, the gate electrode of a specific transistor does not need to be disposed apart from the photodetection element 3. Accordingly, the layout efficiency can be improved.

As described with reference to FIGS. 5, 6, and the like, the gate electrode of the specific transistor includes the first portion P1 located in one pixel 2 of the adjacent pixels 2, the second portion P2 located in the other pixel 2 of the adjacent pixels 2, and the third portion P3 located on the isolator 4 and connected between the first portion P1 and the second portion P2. For example, in this manner, the gate electrodes of the specific transistors of the adjacent pixels 2 can be connected to each other beyond the isolator 4.

As described with reference to FIGS. 4 to 6 and the like, of the plurality of transistors, the gate electrodes of the transistors other than the specific transistors may be disposed in a region other than a region between the gate electrodes of the specific transistors of the adjacent pixels 2. For example, by arranging the gate electrode of each transistor in this manner, the gate electrode can be made common.

As described with reference to FIG. 4 and the like, the gate electrodes of the plurality of transistors of each of the adjacent pixels 2 may be arranged symmetrically with respect to each other across the isolator 4 in plan view (when viewed in the Z-axis direction). It is therefore possible to facilitate the layout design and the like.

As described with reference to FIGS. 2, 4 to 6, and the like, the adjacent pixels 2 may include two pixels 2 arranged side by side in the X-axis direction (horizontal direction) which is an extending direction of the control line HL of each of the plurality of transistors. The gate electrode of the specific transistor may include at least one of the gate electrode FDGG of the transistor FDG, the gate electrode RSTG of the transistor RST, the gate electrode SELG of the transistor SEL, or the gate electrode RSTG of the transistor RST. The transistor FDG is a conversion efficiency switching transistor for switching the conversion efficiency of the floating diffusion FD that accumulates the charge generated in the photoelectric conversion element PD and converts the charge into a voltage. The transistor RST is a reset transistor for discharging the charge accumulated in the floating diffusion FD. The transistor SEL is a selection transistor for selectively outputting a voltage signal (pixel signal) corresponding to the charge accumulated in the floating diffusion FD. For example, the gate electrodes of specific transistors of the adjacent pixels 2 can be made common.

As described with reference to FIGS. 2, 4, 6 to 10, and the like, the adjacent pixels 2 may include two pixels 2 arranged side by side in the Y-axis direction (vertical direction). The gate electrode of the specific transistor may include at least one of the gate electrode RSTG of the transistor RST or the gate electrode OFGG of the transistor OFG. The transistor OFG is an overflow transistor for transferring a charge overflowed in the photoelectric conversion element PD to, for example, the capacitor FD having an MIM structure. For example, the gate electrodes of specific transistors of the adjacent pixels 2 can be made common. In this case, the number of control lines HL_RST connected to the common gate electrode RSTG can be reduced from two to one. Similarly, the number of control lines HL_OFG connected to the common gate electrode OFGG can be reduced from two to one. The layout efficiency can be further improved.

As described with reference to FIGS. 17 and 18 and the like, each of the plurality of pixels 2 may include the photoelectric conversion element PD2 (second photoelectric conversion element) smaller than the photoelectric conversion element PD, and the gate electrode (the gate electrode TGLG2 of the transistor TGL2 and the like) of the transistor connected to the photoelectric conversion element PD2 of each of the plurality of pixels 2 may be disposed closer to the center of the pixel 2 than the gate electrode (the gate electrode TGLG of the transistor TGL and the like) of the transistor connected to the photoelectric conversion element PD in plan view (when viewed in the Z-axis direction). For example, in this manner, the photoelectric conversion element PD1 and the photoelectric conversion element PD2 can be used in combination to improve the layout efficiency in the configuration corresponding to expansion of the dynamic range.

The electronic apparatus 100 including the photodetection element 3 described with reference to FIG. 1 and the like is also one of the disclosed technologies. By providing the photodetection element 3 with improved layout efficiency, it is possible to reduce the size and improve the performance of the electronic apparatus 100.

Note that the effects described in the present disclosure are merely examples and are not limited to the disclosed contents. Other effects may be obtained.

### 3. Application examples to mobile body

The technology according to an embodiment of the present disclosure (present technology) can be applied to various products. For example, the technology according to an embodiment of the present disclosure may be implemented as a device mounted on any type of mobile body such as an automobile, an electric vehicle, a hybrid electric vehicle, a motorcycle, a bicycle, a personal mobility, an airplane, a drone, a ship, and a robot.

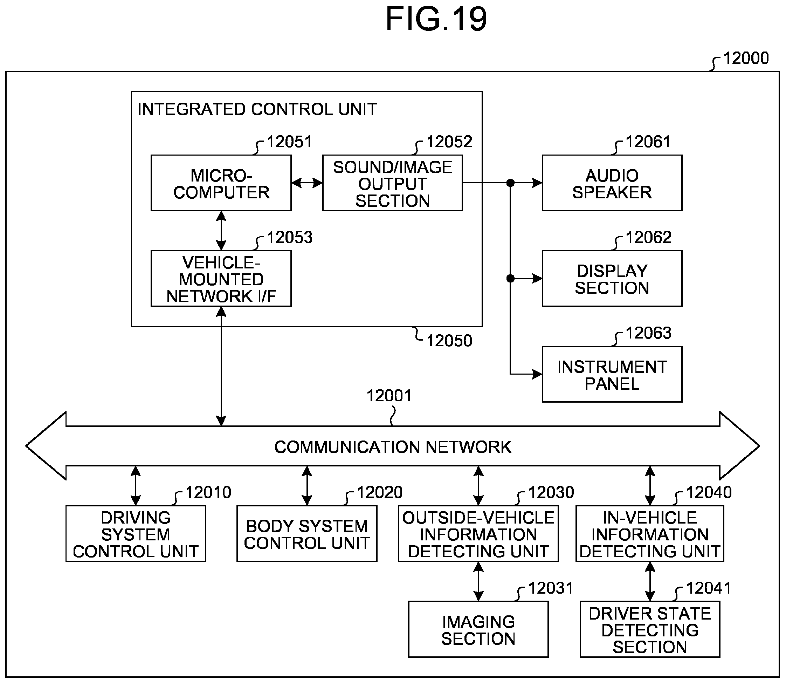

FIG. 19 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 19, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 19, an audio speaker 12061, a display section 12062, and an instrument panel 12063 are illustrated as the output device. The display section 12062 may, for example, include at least one of an on-board display and a head-up display.

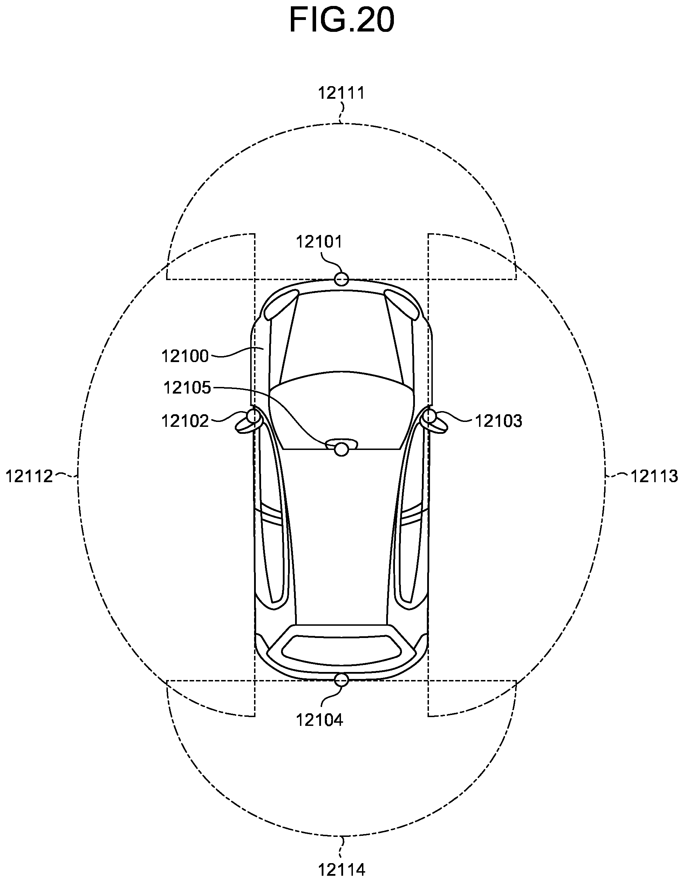

FIG. 20 is a diagram depicting an example of the installation position of the imaging section 12031.

In FIG. 20, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 20 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to an embodiment of the present disclosure can be applied has been described above. The technology according to an embodiment of the present disclosure can be applied to, for example, the imaging section 12031 and the like among the configurations described above. By applying the technology according to an embodiment of the present disclosure to the imaging section 12031 and the like, it is possible to reduce the size, improve the performance, and the like of the imaging section 12031.

Although the embodiments of the present disclosure have been described above, the technical scope of the present disclosure is not limited to the above embodiments as they are, and various modifications can be made without departing from the gist of the present disclosure. The constituent elements of different embodiments and modifications may be appropriately combined.

Note that the present technology can also have the following configurations.
(1) A photodetection element comprising:
   a plurality of pixels disposed in a planar direction; and
   an isolator that extends in a direction intersecting the planar direction between adjacent pixels of the plurality of pixels so as to isolate the adjacent pixels from each other, wherein
   each of the plurality of pixels includes
   a photoelectric conversion element, and
   a plurality of transistors, and
   gate electrodes of specific transistors of the plurality of transistors of each of the adjacent pixels are arranged opposite to each other across the isolator and are connected to each other beyond the isolator in plan view.
(2) The photodetection element according to (1), wherein
   the gate electrodes of the specific transistors include
   a first portion located in one pixel of the adjacent pixels,
   a second portion located in another pixel of the adjacent pixels, and
   a third portion located on the isolator and connected between the first portion and the second portion.
(3) The photodetection element according to (1) or (2), wherein
   of the plurality of transistors, a gate electrode of a transistor other than the specific transistors is disposed in a region other than a region between the gate electrodes of the specific transistors of each of the adjacent pixels.
(4) The photodetection element according to any one of (1) to (3), wherein
   gate electrodes of the plurality of transistors of each of the adjacent pixels are arranged symmetrically across the isolator in plan view.
(5) The photodetection element according to any one of (1) to (4), wherein
   the adjacent pixels include two pixels arranged side by side in a horizontal direction that is an extending direction of a control line of each of the plurality of transistors.
(6) The photodetection element according to (5), wherein
   the gate electrodes of the specific transistors include at least one of
   a gate electrode of a conversion efficiency switching transistor for switching conversion efficiency of a floating diffusion that accumulates charge generated in the photoelectric conversion element and converts the charge into a voltage,
   a gate electrode of a reset transistor for discharging the charge accumulated in the floating diffusion that accumulates the charge generated in the photoelectric conversion element and changes the charge into the voltage, or
   a gate electrode of a selection transistor for selectively outputting a voltage signal corresponding to the charge accumulated in the floating diffusion that accumulates the charge generated in the photoelectric conversion element and changes the charge into the voltage.
(7) The photodetection element according to any one of (1) to (6), wherein
   the adjacent pixels include two pixels arranged side by side in a vertical direction orthogonal to a horizontal direction that is an extending direction of a control line of each of the plurality of transistors.
(8) The photodetection element according to (7), wherein
   the gate electrodes of the specific transistors include at least one of
   a gate electrode of a reset transistor for discharging charge accumulated in a floating diffusion that accumulates the charge generated in the photoelectric conversion element and changes the charge into a voltage, or
   a gate electrode of an overflow transistor for transferring charge overflowed in the photoelectric conversion element to a capacitor.
(9) The photodetection element according to (8), wherein
   the capacitor has a MIM (Metal-Insulator-Metal) structure.
(10) The photodetection element according to any one of (1) to (9), wherein
   each of the plurality of pixels includes a second photoelectric conversion element smaller than the photoelectric conversion element, and
   a gate electrode of a transistor connected to the second photoelectric conversion element of each of the plurality of pixels is disposed closer to a center of each of the pixels than a gate electrode of a transistor connected to the photoelectric conversion element in plan view.
(11) An electronic apparatus comprising
   a photodetection element, wherein
   the photodetection element includes
   a plurality of pixels disposed in a planar direction, and
   an isolator that extends in a direction intersecting the planar direction between adjacent pixels of the plurality of pixels so as to isolate the adjacent pixels from each other,
   each of the plurality of pixels includes
   a photoelectric conversion element, and
   a plurality of transistors, and
   gate electrodes of specific transistors of the plurality of transistors of each of the adjacent pixels are arranged opposite to each other across the isolator and are connected to each other beyond the isolator in plan view.

### Reference Signs List

100 ELECTRONIC APPARATUS
1 PIXEL ARRAY UNIT
2 PIXEL
3 PHOTODETECTION ELEMENT
4 ISOLATOR
5 VERTICAL DRIVE UNIT
6 COLUMN SIGNAL PROCESSOR
7 HORIZONTAL DRIVE UNIT
8 SIGNAL PROCESSOR
9 SYSTEM CONTROLLER
AMP TRANSISTOR
AMPG GATE ELECTRODE
FC CAPACITOR
FCG TRANSISTOR
FCGG GATE ELECTRODE
FCVDD POWER SUPPLY VOLTAGE
FD FLOATING DIFFUSION
FD2 FLOATING DIFFUSION
FDG TRANSISTOR
FDGG GATE ELECTRODE
HL CONTROL LINE
HL_FCG CONTROL LINE
HL_FDG CONTROL LINE
HL_OFG CONTROL LINE
HL_RST CONTROL LINE
HL_SEL CONTROL LINE
HL_TGL CONTROL LINE
HL_TGL2 CONTROL LINE
OFG TRANSISTOR
OFGG GATE ELECTRODE
P1 FIRST PORTION
P2 SECOND PORTION
P3 THIRD PORTION
PD PHOTOELECTRIC CONVERSION ELEMENT
PD2 PHOTOELECTRIC CONVERSION ELEMENT
RST TRANSISTOR
RSTG GATE ELECTRODE
SEL TRANSISTOR
SELG GATE ELECTRODE
TGL TRANSISTOR
TGL2 TRANSISTOR
VDD POWER SUPPLY VOLTAGE
VDD1 POWER SUPPLY VOLTAGE
VDD2 POWER SUPPLY VOLTAGE
VL SIGNAL LINE

## Claims

1. A photodetection element comprising:
a plurality of pixels disposed in a planar direction; and
an isolator that extends in a direction intersecting the planar direction between adjacent pixels of the plurality of pixels so as to isolate the adjacent pixels from each other, wherein
each of the plurality of pixels includes
a photoelectric conversion element, and
a plurality of transistors, and
gate electrodes of specific transistors of the plurality of transistors of each of the adjacent pixels are arranged opposite to each other across the isolator and are connected to each other beyond the isolator in plan view.

2. The photodetection element according to claim 1, wherein
the gate electrodes of the specific transistors include
a first portion located in one pixel of the adjacent pixels,
a second portion located in another pixel of the adjacent pixels, and
a third portion located on the isolator and connected between the first portion and the second portion.

3. The photodetection element according to claim 1, wherein
of the plurality of transistors, a gate electrode of a transistor other than the specific transistors is disposed in a region other than a region between the gate electrodes of the specific transistors of each of the adjacent pixels.

4. The photodetection element according to claim 1, wherein
gate electrodes of the plurality of transistors of each of the adjacent pixels are arranged symmetrically across the isolator in plan view.

5. The photodetection element according to claim 1, wherein
the adjacent pixels include two pixels arranged side by side in a horizontal direction that is an extending direction of a control line of each of the plurality of transistors.

6. The photodetection element according to claim 5, wherein
the gate electrodes of the specific transistors include at least one of
a gate electrode of a conversion efficiency switching transistor for switching conversion efficiency of a floating diffusion that accumulates charge generated in the photoelectric conversion element and converts the charge into a voltage,
a gate electrode of a reset transistor for discharging the charge accumulated in the floating diffusion that accumulates the charge generated in the photoelectric conversion element and changes the charge into the voltage, or
a gate electrode of a selection transistor for selectively outputting a voltage signal corresponding to the charge accumulated in the floating diffusion that accumulates the charge generated in the photoelectric conversion element and changes the charge into the voltage.

7. The photodetection element according to claim 1, wherein
the adjacent pixels include two pixels arranged side by side in a vertical direction orthogonal to a horizontal direction that is an extending direction of a control line of each of the plurality of transistors.

8. The photodetection element according to claim 7, wherein
the gate electrodes of the specific transistors include at least one of
a gate electrode of a reset transistor for discharging charge accumulated in a floating diffusion that accumulates the charge generated in the photoelectric conversion element and changes the charge into a voltage, or
a gate electrode of an overflow transistor for transferring charge overflowed in the photoelectric conversion element to a capacitor.

9. The photodetection element according to claim 8, wherein
the capacitor has a MIM (Metal-Insulator-Metal) structure.

10. The photodetection element according to claim 1, wherein
each of the plurality of pixels includes a second photoelectric conversion element smaller than the photoelectric conversion element, and
a gate electrode of a transistor connected to the second photoelectric conversion element of each of the plurality of pixels is disposed closer to a center of each of the pixels than a gate electrode of a transistor connected to the photoelectric conversion element in plan view.

11. An electronic apparatus comprising
a photodetection element, wherein
the photodetection element includes
a plurality of pixels disposed in a planar direction, and
an isolator that extends in a direction intersecting the planar direction between adjacent pixels of the plurality of pixels so as to isolate the adjacent pixels from each other,
each of the plurality of pixels includes
a photoelectric conversion element, and
a plurality of transistors, and
gate electrodes of specific transistors of the plurality of transistors of each of the adjacent pixels are arranged opposite to each other across the isolator and are connected to each other beyond the isolator in plan view.
